# EUROPEAN PATENT SPECIFICATION

(11) **EP 1 422 985 B1**
(45) Date of publication and mention of the grant of the patent: **05.01.2011**
(21) Application number: 02388071.9
(22) Date of filing: 19.11.2002
(51) Int. Cl.: H05K 9/00

(54) **A method of supporting electronic components and an electronic device with elestic support for an electronic component**
Verfahren zum Tragen von elektronischen Komponenten und Elektronische Vorrichtung und elastische Haltevorrichtung für ein elektronisches Bauelement
Procédé de soutien des composants électroniques et appareil électronique et support élastique pour un composant électronique

(43) Date of publication of application: 26.05.2004
(73) Proprietor: Sony Ericsson Mobile Communications AB, 221 88 Lund (SE)
(72) Inventor: Holmberg, Per, 240 60 Dalby (SE)
(74) Representative: Banzer, Hans-Jörg

(56) References cited:
- EP-A- 1 085 799
- PATENT ABSTRACTS OF JAPAN vol. 2002, no. 10, 10 October 2002 (2002-10-10) & JP 2002 185183 A (FDK CORP), 28 June 2002 (2002-06-28)
- PATENT ABSTRACTS OF JAPAN vol. 2002, no. 03, 3 April 2002 (2002-04-03) & JP 2001 326492 A (CASIO COMPUT CO LTD), 22 November 2001 (2001-11-22)

## Description

### Technical area

The invention relates to a method of providing support for an electronic component in an electronic device comprising a PCB (printed circuit board) and a structural element covering at least a part of the PCB. The invention also relates to such an electronic device.

### Related prior art

Electronic components that are mounted on a PCB (printed circuit board) by soldering suffer from the general problem that cracks may occur in the solder joints due to dynamic forces applied to the electronic device provided with the PCB. The cracks influence the proper functioning of the electronic device since the electrical contact between the electronic component and the PCB is disrupted. The cracks typically occur when the electronic device is dropped, when a high force is applied to the keys of the electronic device or when keys are stroked repeatedly causing fatigue failure to occur.

The cracks occur because the PCB is more flexible than the electronic component. Therefore, when an external force is applied to the electronic device it often causes a small bending of the PCB which in turn stresses the solder joints between the PCB and the electronic component. The problem of crack formation occurs especially in connection with so-called Chip Scale Components and in particular of the BGA-type (Ball Grid Array) that are soldered to the PCB via a plurality of ball-shaped soldering points provided at the underside of the component.

Apart from formation of cracks in the solder joints as such, bending of the PCB may also cause formation of cracks in the electronic component itself, which also leads to malfunctioning of the electronic component and thereby of the electronic device.

Different techniques have been used to avoid crack formation in the soldering joints. One is the so-called "underfill" solution in which an epoxy-type glue is provided around the soldering joints between the PCB and the electronic component. This solution solves the problem in most cases even though situations with crack formation have still occurred. Some of the disadvantages of the underfill solution are that it is rather expensive, the PCB cannot be repaired afterwards and the use of an epoxy material is environmentally undesirable.

Another known technique used for minimising the formation of cracks in the solder joints is the so-called "overfill" solution in which an amount of hot-melt glue is positioned between the electronic component and a structural element such as a shield can or a frame that covers the electronic components. The aim of this solution is to create a rigid structure consisting of the PCB, the electronic component and structural element. This rigid structure makes the PCB less susceptible to bending when an external force is applied to the electronic device. Some disadvantages of this solution are, however, that either the hot-melt glue interconnects the structural element and the electronic component which entails that later repair is difficult, or that a small gap exists between the electronic component and the hot-melt glue which means that the component is not fully supported by the hardened hot-melt glue.

### Object of the invention

Due to the disadvantages of the underfill and overfill solutions described above it is an object of the present invention to provide a new and improved method of providing support for an electronic component in an electronic device comprising a PCB and structural part, such as a shield can or a frame covering the PCB. The method should result in a product in which the problems described above are overcome and should provide full support for the electronic component on the PCB. It is also an object of the invention to provide an electronic device in which full support of the electronic component is ensured.

### Summary of the invention

The object of the invention is achieved by providing the support for the electronic components using the following steps:
- mounting the electronic component on the PCB;
- applying an elastically compressible and shock-absorbing material to the structural element at an area thereof that is adapted to cover the component;
- assembling the PCB and the structural element in such manner that the elastically compressible and shock-absorbing material exerts a pressure on the electronic component towards the PCB.

The object is also achieved by an electronic device as mentioned in the opening paragraph in wich an elastically compressible and shock-absorbing material is provided between the structural element and the electronic component in such manner that the elastically compressible and shock-absorbing material provides a pressure on the electronic component towards the PCB.

By the method and electronic device according to the invention are obtained that the electronic component is fully supported by the elastically compressible and shock-absorbing material that exerts a pressure on the electronic component towards the PCB. This means that any external force applied to the electronic device, such as a key press, will to some degree be absorbed by the elastically compressible and shock-absorbing material which entails less stress on the solder joints between the electronic component and the PCB. It has been observed that the use of an elastically compressible and shock-absorbing material in accordance with the invention has reduced the formation of solder joint cracks considerably in connection with chip scale components, both if a high force is applied to the keys of the electronic device or when keys are stroked repeatedly which generally causes fatigue failure to occur.

In a preferred embodiment the elastically compressible and shock-absorbing material is silicone. This material is often used to create gaskets on frames or other structural parts in the electronic device and it may therefore be applied to other areas of the frames or structural parts without any significant extra cost.

Other suitable materials comprise thermoplastic elastomers that can also be applied to the structural element at low cost.

The elastically compressible and shock-absorbing material may be electrically conductive, whereby it is possible to let the elastically compressible and shock-absorbing material be a functional part of the electronic device.

This is especially suitable if the structural element is an electromagnetic shield can, and the same elastically compressible and shock-absorbing material is applied to an outer edge of the shield can in the same production step as the step in which it is applied to the shield can at an area thereof that is adapted to cover the component. This reduces the manufacturing costs in comparison with a method in which two different materials are employed as the rim supporting material and the electronic component supporting material.

In a preferred embodiment the electronic device is a mobile radio station, such as a mobile telephone.

It shall be emphasised that the term "comprise/comprising" when used in this specification is taken to specify the presence of stated features, integers, steps or components but does not preclude the presence or addition of one or more other features, integers, steps components or groups thereof.

### Description of the drawings

The invention will be described in detail in the following with reference to the drawings in which
Fig. 1 shows a partially disassembled mobile telephone provided with a PCB and an internal frame provided with means for supporting some of the electronic components on the PCB; and
Fig. 2 shows stepwise a method according to the invention of how to provide support for an electronic component on a PCB.

### Detailed description of an embodiment of the invention

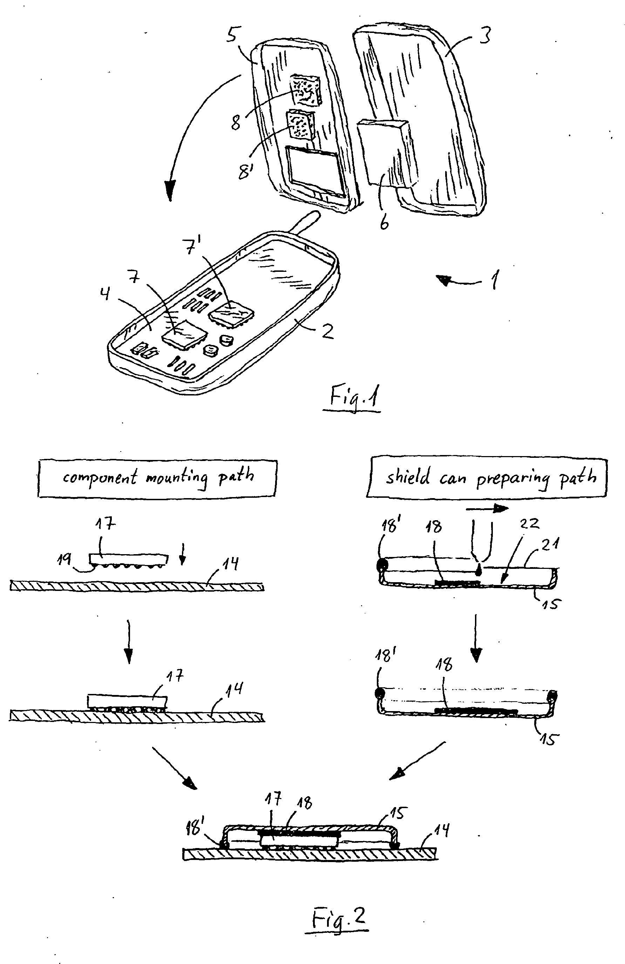

Fig. 1 shows a partially disassembled mobile telephone 1 comprising a front cover 2, a back cover 3, a PCB 4 located in the front cover 1, an internal frame 5 and a battery 6.

The PCB 4 is provided with a number of electronic components, some of which are chip scale components 7,7', e.g. of the so-called BGA type (Ball Grid Array). These types of electronic components are highly exposed to crack formation in the solder joints between the component and the PCB 4 when external forces are applied to the keys of the mobile telephone 1.

The internal frame 5 may be shaped as a shield can that shields the electronic components on the PCB against electromagnetic radiation, or it may be shaped as a structural part of the mobile telephone 1. The internal frame 5 is structured in such manner that it has areas that are adapted to cover the chip scale components 7,7', and according to the invention these areas are provided with a layer of an elastically compressible and shock-absorbing material 8,8' intended to provide a back pressure on the chip scale components 7,7' when the internal frame 5 is mounted on the PCB 4. The internal frame 5 may be connected to the PCB 4 by any conventional method, such as by means of screws, soldering, gluing, etc. The internal frame 5 may also be indirectly connected to the PCB 4 by being firmly connected to the front cover 2 or to the back cover 6.

Fig. 2 shows stepwise a method according to the invention of how to provide support for a chip scale component 17 of the BGA type on a PCB 14 by means of metallic shield can 15. The method initially follows two parallel paths: a component mounting path and a shield can preparing path.

In the component mounting path the chip scale component 17 provided with a ball grid array 19 is mounted on the PCB by any known procedure, such as a surface mounting process. In this process the chip scale component 17 is positioned on the PCB 14, preferably by means of a pick-and-place machine, and the PCB 14 is heated to provide soldering joints between the chip scale component 17 and the PCB 14 at each solder ball in the ball grid array 19. Other electronic components may of course be positioned on the PCB 14, which for clarity reasons are not shown.

In the shield can preparing path the shield can 15, which is shaped as a flat, open metal box, is provided with an elastically compressible and shock-absorbing material, which in the preferred embodiment is an electrical conductive silicone material 18,18', at the outer edge or rim 21 and at the area 22 that is adapted to cover the chip scale component 17 when the shield can 15 is assembled with the PCB 14. The electrical conductive silicone material 18,18' is applied in a layer that, at the rim 21 of the shield can 15, ensures that there is full contact between the shield can rim 21 and the PCB 14, and in a layer at the area that is adapted to cover the chip scale component 17 that is sufficient to ensure that a back pressure is provided on the chip scale component 17 by the electrical conductive silicone material 18 when the shield can 15 is inverted and assembled with the PCB 14 as shown in the last drawing in Fig. 2.

The elastically compressible and shock-absorbing material can be chosen from among a number of materials that have suitable elastic properties. Preferably, the material is a silicone material which could be electrical conductive as described in the example above with reference to Fig. 2, or it could be normal silicone applied in a double-moulding process. Other suitable materials could be thermoplastics elastomers or any other kind of rubber or rubber-like material.

The elastically compressible and shock-absorbing material may be applied to the structural element by any convenient method depending on the material that is used. A person skilled in the art can easily select an appropriate application method once the material to be applied is chosen.

The structural element to which the elastically compressible and shock-absorbing material is applied may be any structural or functional part of an electronic device. As described above with reference to Figs 1 and 2 the element may be an internal frame of the electronic device or a shield can protecting electronic components against electromagnetic radiation. The element could also be the outer casing or cover of the electronic device. The element may of course be made of any suitable material, such as metal or plastics.

## Claims

1. A method of providing support for an electronic component (7,7';17) in an electronic device comprising a PCB (printed circuit board) (4;14) and a structural element (5;15) covering at least a part of the PCB (4;14), said method comprising the steps of:
- mounting the electronic component (7,7';17) on the PCB (4; 14);
- applying an elastically compressible and shock-absorbing material (8,8';18) to the structural element (5;15) at an area (22) thereof that is adapted to cover the component (7,7';17);
- assembling the PCB (4;14) and the structural element (5;15) in such manner that the elastically compressible and shock-absorbing material (8,8';18) exerts a pressure on the electronic component (7,7';17) towards the PCB (4;14).

2. A method according to claim 1, **characterised in that** the elastically compressible and shock-absorbing material (8,8'; 18) is silicone.

3. A method according to claim 1, **characterised in that** the elastically compressible and shock-absorbing material (8,8';18) is a thermoplastic elastomer.

4. A method according to any one of claims 1-3, **characterised in that** the elastically compressible and shock-absorbing material (8,8';18) is electrically conductive.

5. A method according to claim 4, **characterised in that** the structural element is an electromagnetic shield can (15); and that the same elastically compressible and shock-absorbing material (18,18') is applied to an outer edge (21) of the shield can (15) in the same production step as the step in which it is applied to the shield can (15) at an area (22) thereof that is adapted to cover the component (17).

6. An electronic device comprising a PCB (printed circuit board) (4;14) and a structural element (5;15) that covers at least an area of the PCB (4;14) that is provided with an electronic component (7,7';17), **characterised in that** an elastically compressible and shock-absorbing material (8,8';18) is provided between the structural element (5;15) and the electronic component (7,7';17) in such manner that the elastically compressible and shock-absorbing material (8,8';18) provides a pressure on the electronic component (7,7';17) towards the PCB (4;14).

7. An electronic device according to claim 6, **characterised in that** the elastically compressible and shock-absorbing material (8,8';18) is silicone.

8. An electronic device according to claim 6, **characterised in that** the elastically compressible and shock-absorbing material (8,8';18) is a thermoplastic elastomer.

9. An electronic device according to any one of claims 6-8, **characterised in that** the elastically compressible and shock-absorbing material (8,8';18) is electrically conductive.

10. An electronic device according to claim 9, **characterised in that** the structural element is an electromagnetic shield can (15); and that the same elastically compressible and shock-absorbing material (18,18') is applied to an outer edge (21) of the shield can (15) as well as to the shield can (15) at an area (22) thereof that covers the electronic component (17).

11. An electronic device according to any one of claims 6-10, **characterised in that** the electronic device is a mobile radio station, such as a mobile telephone (1)

## Patentansprüche

1. Verfahren zum Schaffen eines Trägers für eine elektronische Komponente (7,7';17) in einer elektronischen Vorrichtung, die eine PCB (gedruckte Schaltungsplatte) (4;14) und ein Bauelement (5;15), das mindestens einen Teil der PCB (4;14) bedeckt, aufweist, wobei das Verfahren folgende Schritte aufweist:
- Anbringen der elektronischen Komponente (7,7';17) an der PCB (4;14);
- Aufbringen eines elastisch zusammendrückbaren und stoßdämpfenden Materials (8,8';18) auf dem Bauelement (5;15) in einem Bereich (22) desselben, der angepasst ist, um die Komponente (7,7';17) zu bedecken;
- Zusammenbauen der PCB (4;14) und des Bauelements (5;15) auf eine solche Art und Weise, dass das elastisch zusammendrückbare und stoßdämpfende Material (8,8';18) auf die elektronische Komponente (7,7';17) einen Druck hin zu der PCB (4;14) ausübt.

2. Verfahren nach Anspruch 1, **dadurch gekennzeichnet, dass** das elastisch zusammendrückbare und stoßdämpfende Material (8,8';18) Silikon ist.

3. Verfahren nach Anspruch 1, **dadurch gekennzeichnet, dass** das elastisch zusammendrückbare und stoßdämpfende Material (8,8';18) ein thermoplastisches Elastomer ist.

4. Verfahren nach einem der Ansprüche 1-3, **dadurch gekennzeichnet, dass** das elastisch zusammendrückbare und stoßdämpfende Material (8,8';18) elektrisch leitfähig ist.

5. Verfahren nach Anspruch 4, **dadurch gekennzeichnet, dass** das Bauelement eine Haube (15) für eine elektromagnetische Abschirmung ist; und dass das gleiche elastisch zusammendrückbare und stoßdämpfende Material (18,18') bei dem gleichen Erzeugungsschritt wie der Schritt, bei dem dasselbe auf der Haube (15) für eine Abschirmung in einem Bereich (22) derselben, der angepasst ist, um die Komponente (17) zu bedecken, aufgebracht wird, auf einem äußeren Rand (21) der Haube (15) für eine Abschirmung aufgebracht wird.

6. Elektronische Vorrichtung, die eine PCB (gedruckte Schaltungsplatte) (4;14) und ein Bauelement (5;15), das mindestens einen Bereich der PCB (4;14), der mit einer elektronischen Komponente (7,7';17) versehen ist, bedeckt, aufweist, **dadurch gekennzeichnet, dass** ein elastisch zusammendrückbares und stoßdämpfendes Material (8,8';18) zwischen dem Bauelement (5;15) und der elektronischen Komponente (7,7';17) auf eine solche Art und Weise vorgesehen ist, dass das elastisch zusammendrückbare und stoßdämpfende Material (8,8';18) auf die elektronische Komponente (7,7';17) einen Druck hin zu der PCB (4;14) liefert.

7. Elektronische Vorrichtung nach Anspruch 6, **dadurch gekennzeichnet, dass** das elastisch zusammendrückbare und stoßdämpfende Material (8,8';18) Silikon ist.

8. Elektronische Vorrichtung nach Anspruch 6, **dadurch gekennzeichnet, dass** das elastisch zusammendrückbare und stoßdämpfende Material (8,8';18) ein thermoplastisches Elastomer ist.

9. Elektronische Vorrichtung nach einem der Ansprüche 6-8, **dadurch gekennzeichnet, dass** das elastisch zusammendrückbare und stoßdämpfende Material (8,8';18) elektrisch leitfähig ist.

10. Elektronische Vorrichtung nach Anspruch 9, **dadurch gekennzeichnet, dass** das Bauelement eine Haube (15) für eine elektromagnetische Abschirmung ist; und dass das gleiche elastisch zusammendrückbare und stoßdämpfende Material (18,18') auf einem äußeren Rand (21) der Haube (15) für eine Abschirmung sowie auf der Haube (15) für eine Abschirmung in einem Bereich (22) derselben, der die elektronische Komponente (17) bedeckt, aufgebracht ist.

11. Elektronische Vorrichtung nach einem der Ansprüche 6-10, **dadurch gekennzeichnet, dass** die elektronische Vorrichtung eine Mobilfunkstation, wie ein Mobiltelefon (1), ist.

## Revendications

1. Procédé pour procurer un support pour un composant électronique (7, 7'; 17) dans un dispositif électronique comportant une plaquette PCB (plaquette à circuit imprimé) (4 ; 14) et un élément structural (5 ; 15) recouvrant au moins une partie de la PCB (4 ; 14), ledit procédé comprenant les étapes qui consistent:
- à monter le composant électronique (7, 7'; 17) sur la PCB (4 ; 14) ;
- à appliquer une matière élastiquement compressible et absorbant les chocs (8, 8'; 18) à l'élément structural (5 ; 15) dans une zone (22) de celui-ci qui est adaptée pour recouvrir le composant (7, 7'; 17) ;
- à assembler la PCB (4 ; 14) et l'élément structural (5 ; 15) d'une manière telle que la matière élastiquement compressible et absorbant les chocs (8, 8'; 18) exerce une pression sur le composant électronique (7, 7'; 17) vers la PCB (4 ; 14).

2. Procédé selon la revendication 1, **caractérisé en ce que** la matière élastiquement compressible et absorbant les chocs (8, 8'; 18) est une silicone.

3. Procédé selon la revendication 1, **caractérisé en ce que** la matière élastiquement compressible et absorbant les chocs (8, 8'; 18) est un élastomère thermoplastique.

4. Procédé selon l'une quelconque des revendications 1 à 3, **caractérisé en ce que** la matière élastiquement compressible et absorbant les chocs (8, 8'; 18) est électriquement conductrice.

5. Procédé selon la revendication 4, **caractérisé en ce que** l'élément structural est un boîtier de blindage électromagnétique (15) ; et ce que la même matière élastiquement compressible et absorbant les chocs (18, 18') est appliquée à un bord extérieur (21) du boîtier de blindage (15) dans la même étape de production que l'étape dans laquelle elle est appliquée au boîtier de blindage (15) dans une zone (22) de celui-ci qui est adaptée pour recouvrir le composant (17).

6. Dispositif électronique comportant une plaquette PCB (plaquette à circuit imprimé) (4; 14) et un élément structural (5; 15) qui recouvre au moins une zone de la PCB (4; 14) qui est pourvue d'un composant électronique (7, 7'; 17), **caractérisé en qu'**une matière élastiquement compressible et absorbant les chocs (8, 8'; 18) est placée entre l'élément structural (5 ; 15) et le composant électronique (7, 7'; 17) d'une manière telle que la matière élastiquement compressible et absorbant les chocs (8, 8'; 18) applique une pression sur le composant électronique (7, 7'; 17) vers la PCB (4 ; 14).

7. Dispositif électronique selon la revendication 6, **caractérisé en ce que** la matière élastiquement compressible et absorbant les chocs (8, 8'; 18) est une silicone.

8. Dispositif électronique selon la revendication 6, **caractérisé en ce que** la matière élastiquement compressible et absorbant les chocs (8, 8'; 18) est un élastomère thermoplastique.

9. Dispositif électronique selon l'une quelconque des revendications 6 à 8, **caractérisé en ce que** la matière élastiquement compressible et absorbant les chocs (8, 8'; 18) est électriquement conductrice.

10. Dispositif électronique selon la revendication 9, **caractérisé en ce que** l'élément structural est un boîtier de blindage électromagnétique (15) ; et ce que la même matière élastiquement compressible et absorbant les chocs (18, 18') est appliquée à un bord extérieur (21) du boîtier de blindage (15) ainsi qu'au boîtier de blindage (15) dans une zone (22) de celui-ci qui recouvre le composant électronique (17).

11. Dispositif électronique selon l'une quelconque des revendications 6 à 10, **caractérisé en ce que** ce dispositif électronique est une station radio mobile, telle qu'un téléphone mobile (1).
